# EUROPEAN PATENT APPLICATION

(11) **EP 4 842 149 A1**
(43) Date of publication of application: **18.11.2026**
(21) Application number: 25176466.8
(22) Date of filing: 14.05.2025
(51) Int. Cl.: H05K 3/42

(54) **COMPONENT CARRIER AND METHOD FOR MANUFACTURING A COMPONENT CARRIER**

(71) Applicant: AT & S Austria Technologie & Systemtechnik Aktiengesellschaft, 8700 Leoben-Hinterberg (AT)
(72) Inventor: STEINER, Sandra, 8700 Leoben (AT); OELLER, Heinz-Peter, 8051 Graz (AT); WOLFSBERGER, Friedrich, 8733 St. Marein - Feistritz (AT)
(74) Representative: Donatello, Daniele

(57) **Abstract**

The present invention relates to a component carrier (100) and a method for manufacturing thereof, wherein the component carrier (100) comprises a stack (110) comprising at least one electrically conductive layer structure (103, 104);
at least one electrically insulating layer structure (102) comprising at least one through hole (120) passing through said at least one electrically insulating layer structure (102);
an electrically conductive structure (130) in contact with a sidewall of the at least one through hole (120). Said electrically conductive structure (130) partially vertically extends along the vertical extension of the sidewall.

## Description

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

For example, in manufacturing a component carrier comprising at least one electrically insulating layer structure, said electrically insulating layer structure comprising a through hole, the "void-free" filling of said through hole with an electrically conductive structure may be challenging. Especially, filling a through hole with electrically conductive material may be challenging the smaller the lateral extension of the at least one through hole in combination with the higher the thickness of the at least one through hole.

There may be a need to create a component carrier comprising a stack comprising at least one electrically conductive layer structure, at least one electrically insulating layer structure comprising at least one through hole passing through said at least one electrically insulating layer structure, an electrically conductive structure in contact with a sidewall of the at least one through hole, said electrically conductive structure partially vertically extending along the vertical extension of the sidewall.

In order to achieve the object defined above, a component carrier and a method of manufacturing the component carrier according to the independent claims are provided. The dependent claims describe advantageous embodiments.

### Field of the Invention

The present invention generally relates to a component carrier comprising a stack comprising at least one electrically conductive layer structure and at least one electrically insulating layer structure. Said at least one electrically insulating layer structure comprises at least one through hole passing through said at least one electrically insulating layer structure. Furthermore, an electrically conductive structure is in contact with a sidewall of the at least one through hole. Said electrically conductive structure partially vertically extends along the vertical extension of the sidewall.

Further, the present invention relates to a method for manufacturing a component carrier as described.

According to a first aspect of the present invention, a component carrier is provided, wherein the component carrier comprises a stack comprising at least one electrically conductive layer structure and at least one electrically insulating layer structure. Said at least one electrically insulating layer structure comprises at least one through hole passing through said at least one electrically insulating layer structure. Furthermore, an electrically conductive structure is in contact with a sidewall of the at least one through hole. Said electrically conductive structure (only) partially vertically extends along the vertical extension of the sidewall. Preferably, the component carrier may comprise a plurality of through holes passing through said at least one electrically insulating layer structure. The distribution of the plurality of through holes provided in the electrically insulating layer structure may be irregular. Preferably, the component carrier may comprise a first portion having more through holes passing through the at least one electrically insulating layer structure in regard to an area, for example 10 mm², in comparison to a second portion. Additionally, the component carrier may comprise a second portion having less through holes passing through the at least one electrically insulating layer structure in regard to another area, for example 10 mm², in comparison to the first portion. In other words, the component carrier may have at least two portions each having a respective (at least one or a plurality of) through hole(s) to area ratio passing through the at least one electrically insulating layer structure.

According to the second aspect of the present invention, a method of manufacturing a component carrier is provided, wherein the method comprises the steps of: providing a stack comprising at least one electrically conductive layer structure and at least one electrically insulating layer structure; forming at least one through hole in the at least one electrically insulating layer structure, such that the at least one through hole passes through said at least one electrically insulating layer structure; providing an electrically conductive structure in contact with a sidewall of the at least one through hole, such that said electrically conductive structure partially vertically extends along the vertical extension of the sidewall. Preferably, providing the electrically conductive structure may be done after the at least one through hole is formed in the at least one electrically insulating layer structure.

A component carrier according to the first aspect of the present invention is created, in which at least one through hole passing through the at least one electrically insulating layer structure of the component carrier is partially filled with an electrically conductive structure. Said electrically conductive structure partially vertically extends along the vertical extension of the sidewall of the at least one through hole. This may ensure a reliable and void-free filling of the at least one through hole, due to the fact that the partial extension of the electrically conductive structure is the outcome of the provision of the (electrically) conductive material in an amount to reliably fully fill the central portion of the at least one through hole or the plurality of said through holes. In the latter case, the plurality of through holes may be distributed in the planar extension of the least one electrically insulating layer structure not following only one and/or a regular (patterned) distribution, avoiding the risk of an unbalanced filling of conductive structure between the through hole by the partial removal of the conductive material at the surface side of the least one electrically insulating layer structure (or in other words at one extremity of the through hole). The remaining part of the at least one and/or the plurality of through holes may be eventually subsequently filled with a further conductive (layer) structure constantly (at least vertically) extending throughout the respective surface of the least one electrically insulating layer structure. The at least one through hole filled with the electrically conductive structure may be configured to transmit heat and/or an electrical signal and/or an electrical current. Said void-free filling of the at least one through hole may ensure a low-loss transmission of the heat and/or the electrical signal and/or the electrical current. The first and second aspect of the present invention may provide the opportunity to reliably void-free fill a plurality of through holes, wherein at least two of the plurality of the through holes comprises different distribution and/or shape. The different shape of the respective through holes may comprise a different external shape and/or a different extension in at least one dimension, for example a diameter of the through hole. By the provision of the electrically conductive structure, at a central region only of the at least one through hole in regard to thickness direction, void-free filling of the at least one through hole may be ensured, improving from the known electrically conductive structure resulting with a not constant thickness inside and/or extending the through hole, in particular due to the specific dimension-volume of said at least one through hole and/or due to the different through holes distributions. This may be especially beneficial when the component carrier is used for high performance applications, for example a server.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components. The component carrier may be configured to transmit electromagnetic waves.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more stacks and/or more than at least two electrically conductive layer structures. A component carrier may, for example, also comprise a solder resist layer structure and/or a protective layer structure. A protective layer structure may also be functionalized as an electrically conductive layer structure for at least one component.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper and/or contain at least a certain and defined amount of copper as it is well-known from prior art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microoptoelectromechanical system (MOEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component. Additionally or alternatively, the component may comprise a polymer waveguide and/or (optical) lenses and/or collimators and/or ferrules.

In the context of the present application, the term "stack" may particularly denote an arrangement of multiple planar layer structures which are mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like and/or nanowires. These electrically conductive structures may for example be etched from copper sheets and may, for example, be laminated onto an electrically non-conductive or electrically insulating layer structure, which the component carrier may comprise additionally in at least one embodiment. Additionally or alternatively, the electrically conductive layer structure may be produced by an additive process, for example SAP or mSAP, wherein SAP stands for "Semi-Additive Process" and mSAP denotes the "modified Semi-Additive Process", wherein both processes SAP and mSAP are well-known from prior art. In an example, the SAP and/or mSAP may comprise acidic conditions and/or alkaline conditions.

In at least one embodiment, the at least one electrically conductive layer structure of the component carrier comprises at least one of the following group consisting of: copper, aluminum, nickel, silver, gold, palladium, molybdenum, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT) or polyaniline, respectively.

In the context of the present application, the term "electrically insulating layer structure" may denote a layer structure which is electrically non-conductive. The term "electrically insulating layer structure" is in particular used as a synonym of "organic electrically insulating layer structure" in the context of the present application. Additionally or alternatively, the term "electrically insulating layer structure" may comprise the inorganic layer structure.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or sapphire and/or zirconia and/or cordierite and/or cordierite and/or steatite and/or forsterite and/or yttria and/or tungsten comprising ceramic material. Additionally or alternatively, the inorganic layer structure may comprise glass/ceramic composite material and/or non-oxide based glasses and/or glass-ceramics comprising low atomic weight elements. Yet, in another example, the inorganic layer structure may comprise semi-conducting material, for example silicon and/or germanium and/or silicon oxide and/or germanium oxide and/or silicon carbide and/or gallium nitride and/or gallium arsenide and/or indium phosphide. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS₂, CuGaO₂, AgAlO₂, LiGaTe₂, AgInSe₂, CuFeS₂, BeO.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, (hollow) spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures. In an example, the electrically insulating layer structure may have a thickness larger than 300 µm, in particular may be in the range from 300 µm to 1500 µm. In another example, the electrically insulating layer structure may have a thickness smaller than 300 µm, in particular in the range from 10 µm to 300 µm.

In the context of the present application, the term "layer structure" may particularly denote a continuous layer, a patterned layer or a plurality of nonconsecutive islands within a common plane. A layer structure can comprise at least one protruding element such as, for example, one or more solder bumps, copper bumps, vias, pillars or other bonding structures like these, wherein the at least one protruding element may in particular protrude beyond the surface of a layer structure.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "thickness direction" or "stacking direction" may particularly refer to a direction perpendicular to a planar extension of at least one layer structure of the stack.

In the context of the present application, the term "cavity" may particularly denote a recess or hollow space having been created within a structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner.

In the context of the present application, the term "through hole" may particularly denote an opening been created within a structure of the component carrier, in particular an electrically insulating layer structure. The through hole may pass from a first main surface of the electrically insulating layer structure through the entire thickness of the electrically insulating layer structure along the thickness direction to the second opposed surface of the electrically insulating layer structure. The through hole may have a lateral extension being smaller than 1 mm, in particular smaller than 500 µm. Preferably, the through hole may have a lateral extension in the range from 30 µm to 250 µm. The through hole may comprise a first extremity being associated to the first main surface of the electrically insulating layer structure. Additionally, the through hole may comprise a second extremity being associated to the second opposed main surface of the electrically insulating layer structure.

In the context of the present application, the term "electrically conductive structure" may particularly denote a structure comprising electrically conductive material. Additionally, the electrically conductive structure may comprise thermally conductive material. Preferably, the electrically conductive material may comprise metal, for example copper and/or silver and/or titanium. Additionally, the electrically conductive structure may comprise electrically insulating material. For example, the electrically conductive structure may comprise a paste material, being composed of electrically conductive particles hosted in an electrically insulating matrix material. Preferably, the electrically conductive structure may comprise an electrical conductivity higher than 10⁵ S/m, in particular 10⁶ S/m. The electrically conductive structure may comprise a metal created by a chemical and/or physical vapor deposition process. Additionally or alternatively, the electrically conductive structure may comprise a metal created by an electro-less deposition process and/or a galvanic plating process.

In the context of the present application, the term "sidewall" may particularly denote a lateral wall of a structure or body, which connects the two opposed main surface of the structure or body in thickness direction. The sidewall may comprise a straight shape. Additionally or alternatively, the sidewall may comprise a non-straight shape, for example a curved shape or a wave-like shape.

In the context of the present application, the term "said electrically conductive structure partially vertically extending along the vertical extension of the sidewall" may particularly denote that a portion (in other words, not the whole vertical extension) of the sidewall of the at least one through hole is in contact with the electrically conductive structure. Preferably, said (direct) contact may trend in thickness direction. In an example, the contact of a portion of the sidewall of the at least one through hole with the electrically conductive structure may be at least 10% in regard to the entire thickness of the at least one through hole. In another example, the contact of a portion of the sidewall of the at least one through hole with the electrically conductive structure may be smaller than 98%, in particular 90%, in regard to the entire thickness of the at least one through hole.

### Description of Exemplary Embodiments

According to a preferred embodiment of the present invention, the electrically conductive structure may be vertically distanced from one of the two main surfaces of the at least one electrically insulating layer structure. Preferably, the distance from one of the two main surfaces of the at least one electrically insulating layer structure to the electrically conductive structure may be larger than 2 µm, in particular larger than 5 µm. Said distance from one of the two main surfaces of the at least one electrically insulating layer structure to the electrically conductive structure may create a dimple inside the at least one through hole which may create an interaction portion. Said interaction portion may enhance the mechanical interaction between the electrically conductive structure and a further layer structure, for example an electrically conductive layer structure, and/or a cap structure.

According to another embodiment of the present invention, the electrically conductive structure may be vertically distanced from both of the two main surfaces of the at least one electrically insulating layer structure. In an example, the distances of the electrically conductive structure to the respective first main surface and the second main surface of the electrically insulating layer structure may be larger than 2 µm, in particular larger than 5 µm. This may bring the advantage of enhancing the mechanical interaction between the electrically conductive structure and further layer structures at both sides of the component carrier. Said two distances may protect, in particular mechanically protect, the electrically conductive structure from the environment, since the electrically conductive structure is intended in the electrically insulating layer structure, in particular in regard to both main surfaces of the electrically insulating layer structure.

According to a further embodiment of the present invention, the distance between the electrically conductive structure and one of the two main surfaces of the at least one electrically insulating layer structure may be different than the distance of the electrically conductive structure and the other one of the two main surfaces of the at least one electrically insulating layer structure. In an example, the distance between the electrically conductive structure and one of the two main surfaces of the at least one electrically insulating layer structure and the distance of the electrically conductive structure and the other one of the two main surfaces of the at least one electrically insulating layer structure may be in the range from 2 µm to 50 µm, wherein the distance between the electrically conductive structure and one of the two main surfaces of the at least one electrically insulating layer structure and the distance of the electrically conductive structure and the other one of the two main surfaces of the at least one electrically insulating layer structure are different. In an example, the distance between the electrically conductive structure and one of the two main surfaces of the at least one electrically insulating layer structure may be in the range from 2 µm to 20 µm, whereas the distance of the electrically conductive structure and the other one of the two main surfaces of the at least one electrically insulating layer structure may be in the range from 20 µm to 50 µm. The electrically conductive structure may not be perfectly aligned with the center of the at least one through hole, nevertheless at the same time the electrically conductive structure may be provided such, that it comprises a good interaction with the sidewall of the at least one through hole and thus a reliable integrity of the electrically conductive structure and the at least one electrically insulating layer structure is ensured. This product feature may be a fingerprint of the applied manufacturing method where for example the removal of part of the electrically conductive structure (i.e. at the extremities of the at least one through hole) is provided by chemical reaction (i.e. by chemical etching) then not assure a perfect repeatability of the amount of the material removed. In an alternative embodiment, the distance between the electrically conductive structure and one of the two main surfaces of the at least one electrically insulating layer structure may be the same as the distance of the electrically conductive structure and the other one of the two main surfaces of the at least one electrically insulating layer structure, being the possible footprint of a mechanical machinery removal of the conductive structure.

According to a preferred embodiment of the present invention, the distance between the electrically conductive structure and the one of the two main surfaces may vary along the horizontal extension of said electrically conductive structure. Preferably, the in a cross sectional view the one of the two main surfaces may have a curved shape or a wave-like shape. This possible footprint of a specific kind of material removal process (i.e. chemical etching, see above), may increase the surface of the electrically conductive structure and thus may increase the adhesion of the electrically conductive structure with an adjacent material, for example a metal. In an alternative embodiment, the distance between the electrically conductive structure and the one of the two main surfaces may be constant along the horizontal extension of said electrically conductive structure (possible for example by a mechanical machinery removal) but due to an eventual inclination/rounding of the extremity of the electrically conductive structure, an increasing of the surface can be reached.

According to another embodiment of the present invention, the electrically conductive structure may comprise a layer structure partially covering the sidewall of the at least one through hole. Preferably, the layer structure comprises at least one layer structure.

According to a further embodiment of the present invention, the electrically conductive structure may comprise at least two layer structures. Preferably, the at least two layer structures may comprise a seed layer, for example created by a physical and/or chemical vapor deposition process and/or an electro-less plating process, and a metal layer, for example created by a galvanic plating process. The at least one, in particular at least two, layer structure(s) may enhance the adhesion between the sidewall of the though hole with the electrically conductive structure. Additionally or alternatively, the at least one, in particular at least two, layer structure(s) may enable a galvanic plating process of the electrically conductive structure, which reduces the time of providing the electrically conductive structure in the at least one through hole. In an example, the at least one, in particular at least two, layer structure(s) may be smaller than 5 µm, in particular may be in the range from 20 nm to 1 µm. In a further example the material of the two layer structures may be different, for example a material of the first layer may comprise palladium or titanium, whereas a material of the second layer may comprise copper. Preferably, at least one, in particular at least two, layer structure(s) may comprise metal.

According to a preferred embodiment of the present invention, the electrically conductive structure may fill at least partially, in particular fully, the volume of the at least one through hole along (only) a partial vertical extension of the at least one through hole. This may ensure a high volume content filled by the electrically conductive structure inside the at least one through hole and thus may enable a high transmission of an electric current, for example larger than 20 A, in particular larger than 50 A.

According to another embodiment of the present invention, the portion of the electrically conductive structure filling at least partially, in particular fully, the volume of the at least one through hole (along a partial vertical extension of the at least one through hole) may comprise a bridging structure. Said bridging structure may be in contact with both opposed sidewalls of the at least one though hole. The bridging structure may be created by a separated process step. This may ensure a reliable filling of the at least one through hole with the electrically conductive structure, especially when the at least one through hole comprises a thickness to lateral extension ratio being larger than 5. The bridging structure may be used as a base layer for providing plated metal structure.

According to a further embodiment of the present invention, the electrically conductive structure may comprise a plated metal structure, in particular plated copper structure, said plated metal structure being in contact with the (one or at least two) layer structure(s) comprised in the electrically conductive structure. Additionally or alternatively, the electrically conductive structure may comprise a paste structure being in contact with the (one or at least two) layer structure(s) comprised in the electrically conductive structure. A plated metal structure may be created in a straightforward and reliable way. Additionally, the plated metal structure may have a high electrical and/or thermal conductivity ensuring a low-loss transmission of an electric current and/or an electric signal.

According to a preferred embodiment of the present invention, the grain size of the plated metal structure may be different, in particular larger, than the grain size of the layer structure. This may be related due to different manufacturing conditions of the plated metal structure and the layer structure. The plated metal structure may be created using different plating parameters in comparison to the plating parameters creating the layer structure, resulting in respective grain sizes. This may optimize the time of creating the plated metal structure and the layer structure while at the same time it may ensure a void-free provision of the electrically conductive structure.

According to a further embodiment of the present invention, the at least one through hole may comprise a plug structure. The plug structure may comprise a paste structure. Preferably, the plug structure may extend from the first main surface of the electrically insulating layer structure to the second main surface of the electrically insulating layer structure. The plug structure may have a cylindrical shape and/or a pipe-like shape. Preferably, the at least one through hole may not have to be fully filled with electrically conductive material, in particular the electrically conductive structure. When a plug structure is comprised in the at least one through hole, the electrically conductive structure may be still provided at the at least one sidewall of the at least one through hole and thus may transmit an electrical signal through the thickness of the at least one through hole. The plug structure may occupy a volume ratio larger than 60% of the at least one through hole and thus may save energy and material, since valuable material of the electrically conductive structure and provided such can be saved.

According to a further embodiment of the present invention, the plug structure may comprise an electrically insulating material and/or a magnetic material and/or is perforated. Preferably, the material of the plug structure may be different than the material of the electrically conductive structure and/or the electrically conductive layer structure and/or the electrically insulating layer structure. The respective plug material may impart physical properties to the stack, and thus may create a new functionality with in the stack, for example an interaction with magnetic field.

According to a preferred embodiment of the present invention, the at least one electrically conductive layer structure may be provided on one main surface of the at least one electrically insulating layer structure. Preferably, the electrically conductive layer structure and the electrically conductive structure may comprise the same material.

According to another embodiment of the present invention, at least two electrically conductive layer structures may be provided, each one on one of the two main surfaces of the at least one electrically insulating layer structure. The at least one, in particular at least two, electrically conductive layer structure(s) may be an element of the stack. Preferably, the at least one, in particular at least two, electrically conductive layer structure(s) may have a thickness in the range from 1 µm to 150 µm. Alternatively, the at least one, in particular at least two, electrically conductive layer structure(s) may have a thickness in the range from 150 µm to 500 µm. This may bring the advantage of transmitting an electrical signals and/or electric current in lateral direction in and/or outside the stack.

According to a preferred embodiment of the present invention, the at least one electrically conductive layer structure may be in contact with the electrically conductive structure. Preferably, the at least one electrically conductive layer structure may be in direct contact with the electrically conductive structure. Additionally or alternatively, the at least one electrically conductive layer structure may be in indirect contact with the electrically conductive structure. This may bring the advantage of transmitting an electrical signal and/or electric current and/or heat in regard to thickness direction in a short way.

According to another embodiment of the present invention, the at least one electrically conductive layer structure may be in contact with one (vertical) extremity of the electrically conductive structure. This may bring the advantage of transmitting an electrical signal and/or electric current between the aforementioned elements of the stack thereby ensure low losses during the transmission due to the high electrical conductivity of the electrically conductive structure and the electrically conductive layer structure and the void-free connection.

According to a further embodiment of the present invention, the at least one electrically conductive layer structure may extend at least partially internally in the at least one through hole. This may bring the advantage of ensuring a reliable mechanical interaction between the electrically conductive structure and the electrically conductive layer structure. This may strengthen the electrically conductive layer structure in contact with the electrically conductive structure against shear forces applied to the electrically conductive layer structure during manufacturing.

According to a preferred embodiment of the present invention, at least two electrically conductive layer structures may be in contact with the electrically conductive structure. This may ensure a low-loss transmission of an electrical signal and/or electric current from the first main surface through the at least one through hole to the second main surface of the stack or vice versa.

According to another embodiment of the present invention, the at least two electrically conductive layer structures may be provided at the two opposed (vertical) extremities of the electrically conductive structure. This may bring the advantage of transmitting an electric signal and/or electric current and/or heat through the at least one through hole in a short way between two electrically conductive layer structures.

According to a further embodiment of the present invention, the at least two electrically conductive layer structures may extend at least partially internally in the at least one through hole. This may enhance the mechanical stability of the stack, since the respective at least two electrically conductive layer structures may interact with the sidewall(s) of the at least one through hole and thus the at least two electrically conductive layer structures may interact in horizontal and vertical direction with the at least one electrically insulating layer structure.

According to a preferred embodiment of the present invention, a cap structure may be provided in or at the extremity of the at least one through hole. Preferably, at least two cap structures may be provided. A first cap structure may be provided in or at the first extremity of the electrically conductive structure and a second cap structure may be provided in or at the second extremity of the electrically conductive structure. The cap structure may be provided by a separate manufacturing step, for example by a galvanic plating step. The cap structure may electrically connect the electrically conductive structure with the exposed main surface(s) of the stack.

In the context of the present application, the term "cap structure" may particular denote a physical body located at one extremity of the electrically conductive structure and eventually at one main surface of the at least one electrically insulating layer structure, configured to close and/or delimit the internal space-material defined by the electrically conductive structure, preferably assuring the electrical connection with said electrically conductive structure. Preferably, the cap structure may cover the at least one through hole. . Additionally or alternatively, the cap structure may comprise a pad and/or a pillar. Preferably, the cap structure may comprise an electrical conductivity larger than 10⁵ S/m, in particular larger than 10⁶ S/m.

According to another embodiment of the present invention, the cap structure may cover at least partially, in particular fully, the extremity of the at least one through hole. This may bring the advantage of the filling, at least partially, the portion of the at least one through hole not filled by the electrically conductive structure, and/or of mechanically and/or chemically protecting the at least one electrically conductive structure from the environment, for example from oxidation and/or scratching.

According to a further embodiment of the present invention, the cap structure may comprise an electrically conductive material. Preferably, the cap structure may comprise copper and/or titanium. Additionally or alternatively, the cap structure may comprise silver and/or palladium. The cap structure may comprise electrically conductive material created by a galvanic plating process step. This may bring the advantage of electrically connecting the electrically conductive structure by the cap structure.

According to a preferred embodiment of the present invention, the cap structure may comprise at least one, in particular at least two layer structures. Preferably, the at least two layer structures may comprise different materials. The first layer structure may comprise copper, whereas the second layer structure may be free from copper. The second layer structure may comprise a metal being different from copper, for example titanium and/or silver. Preferably, the cap structure may be manufactured by a galvanic plating process step and/or a physical vapor deposition process step. Additionally or alternatively, the cap structure may be manufactured by a chemical vapor deposition process step and/or an electro-less deposition process step. This may bring the advantage of providing a plurality of cap structures within one process step in a straightforward manner and thus may save time.

According to another embodiment of the present invention, the cap structure may comprise the at least one electrically conductive layer structure (composing the stack). This may bring the advantage of providing the at least one electrically conductive layer structure and the cap structure within one, in particular the same, process step and thus may simplify the manufacturing process of the component carrier.

According to a further embodiment of the present invention, the cap structure may comprise an external portion in contact with a main surface of the electrically insulating layer structure. Optionally, at least a portion of the cap structure may be free from contact with said main surface of the electrically insulating layer structure. This may bring the advantage of enlarging the contact area of the cap structure and the at least one electrically insulating layer structure. Consequently, this may result in a better mechanical interaction between the cap structure and the at least one electrically insulating layer structure, preferably using a portion of at least one electrically conductive layer structure composing the stack.

According to a preferred embodiment of the present invention, the external portion has a lateral extension larger than the lateral extension of the at least one through hole. This may bring the advantage of having a larger exposed area of the cap structure in comparison to the area of the extremity of the at least one through hole, preferably using a portion of at least one electrically conductive layer structure composing the stack. A larger exposed area may give the possibility to easily mechanically connect the cap structure with a further material, for example an electrically conductive layer structure and/or an electrically insulating layer structure.

According to another embodiment of the present invention, the cap structure may be in contact with the electrically conductive structure, in particular with the extremity of the electrically conductive structure distanced from one of the two main surfaces of the at least one electrically insulating structure. This may bring the advantage of ensuring a reliable transmission of an electric signal and/or electric current and/or heat between the cap structure and the electrically conductive structure.

According to a further embodiment of the present invention, the contact between the cap and the electrically conductive structure may define a boundary profile, in particular said boundary profile having an irregular and/or curved surface extension. Alternatively, the boundary profile may have a regular shape and/or a straight shape. The may bring the advantage assuring the full contact between the cap and the electrically conductive structure irrespective of the extension and/or shape of the boundary profile, taking the advantage of the irregular and/or curved surface extension to enlarge the contact surface between the cap structure and the electrically conductive structure, resulting in a reliable mechanical interaction between the cap structure and the electrically conductive structure.

According to a preferred embodiment of the present invention, the cap structure may comprise a first layer structure in contact with the electrically conductive structure and a second layer structure in contact with the first layer structure at the opposed side with respect to the side of the electrically conductive structure. Preferably, the first layer structure may have a thickness in the range from 10 nm to 5 µm. The second layer structure may have a thickness in the range between 5 µm to 50 µm. The first layer structure may be configured as an adhesion promotor and thus may ensure a reliable connection between the electrically conductive structure and the second layer structure of the cap structure.

According to a further embodiment of the present invention, the first layer structure of the cap structure may comprise a different material than the second layer structure of the cap structure and/or the electrically conductive structure. Preferably, the first layer structure of the cap structure may comprise titanium and/or palladium and/or silver. In other words, the first layer structure of the cap structure may be free of copper. The electrically conductive structure and/or the second layer structure of the cap structure may comprise copper. Optionally, the first layer structure of the cap structure may comprise the same material as the second layer structure of the cap structure and/or the electrically conductive layer structure. The first layer structure of the cap structure may act as a diffusion barrier layer. This may hinder metal migration and thus ensure a long-life stability of the cap structure.

According to a preferred embodiment of the present invention, the first layer structure of the cap structure may be in contact with at least two of: the second layer structure of the cap structure; the at least one layer, in particular the at least two, layer(s) of the electrically conductive structure, the bridging structure; the at least one electrically insulating layer structure. This may bring the advantage of (electrically) connecting the aforementioned elements with each other.

According to another embodiment of the present invention, the first layer structure of the cap structure may have a different lateral extension, in particular a shorter lateral extension, than the second layer structure of the cap structure. Additionally or alternatively, the first layer structure of the cap structure may have the same lateral extension as the second layer structure of the cap structure. This may be a fingerprint feature of the used manufacturing process, for example by applying two etching process steps. Such different lateral extension of the first layer structure and the second layer structure of the cap structure may create an interaction point, which may be use for a mechanical interaction of an electrically insulating material, for example an electrically insulating layer structure, with the cap structure.

According to a further embodiment of the present invention, the electrically conductive structure may comprise at least one layer structure defining an internal volume, said volume being filled by a plug structure, for example a plug (structure) as above described suitable to fill an internal volume defined by the electrically conductive structure. The plug structure may impart physical properties to the electrically conductive structure, for example elasticity. Additionally or alternatively, by providing a plug structure in the internal volume of the electrically conductive structure may ensure that the internal volume is filled void-free, since the provision of the plug structure is couple to an application of vacuum during the process step.

According to a preferred embodiment of the present invention, the plug structure may extend beyond the respective extremity of the electrically conductive structure, in particular the extremity distanced from the respective main surface of the at least one electrically insulating structure. This eventual footprint of the plug structure provision before the removal of the conductive material resulting in the partial extension of the electrically conductive structure along the vertical extension of the sidewall of the through hole may bring the advantage of enlarging the surface of interaction between the electrically conductive structure and the cap structure, in particular the first layer structure of the cap structure, and thus resulting in a reliable mechanical interaction between the electrically conductive structure and the cap structure. Additionally or alternatively, the plug structure may be intended in regard to the respective extremity of the electrically conductive structure or may be flush with the respective extremity of the electrically conductive structure.

According to another embodiment of the present invention, a recessed ring may be formed by the sidewall of the at least one through hole, the extremity of the electrically conductive structure and a lateral wall of the plug. The recessed ring may be at least partially, in particular fully, filled by the first layer structure, in particular the second layer structure, of the cap structure. Said recessed ring, that may be the footprint of the removal of the (electrically) conductive material resulting in the partial extension of the electrically conductive structure along the vertical extension of the sidewall of the through hole when the plug structure is already provided in the through hole, may bring the advantage forming an interaction portion, for example a barb, and thus may enhance the mechanical interaction between the cap structure and the electrically conductive structure.

According to a preferred embodiment of the present invention, the plug structure may extend beyond the main surface of the electrically insulating layer structure.. This eventual footprint of the plug provision filling a through hole extending not only through at least one of the plurality of electrically insulating layer structure, but also through at least one electrically conductive layer structure, may bring the advantage of reducing the needed amount of electrically conductive material to have an external planar surface (being part of the volume in the stack filled by the additional protruding portion of the plug structure) and/or of creating an interaction portion between the cap structure and the electrically conductive structure. Said interaction portion may enhance the resistance of shear stresses applied to the cap structure and thus may enhance the integrity between the cap structure and the electrically conductive structure. Additionally or alternatively, the plug structure may be intended in the main surface of the electrically insulating layer structure or may be flush with the main surface of the electrically insulating layer structure. Preferably, the plug structure may extend beyond both main surfaces of the electrically insulating layer structure.

According to another embodiment of the present invention, the plug structure may comprise at least one of: electrically insulating material, (thermally and/or electrically) conductive material, magnetic material, bulk material, paste material. This may bring to advantage of imparting physical and/or chemical properties to the electrically conductive structure, for example elasticity and/or ability to interact with a magnetic field.

According to a further embodiment of the present invention, the sidewall of the at least one through hole may comprise a slated shape. In an example, the sidewall of the at least one through hole may comprise a straight slanted shape. In another example, the sidewall of the at least one through hole may comprise a curved slated shape. The slated shape may comprise any form which is inclined to the stacking direction. For example, the slated shape may be a frustoconical shape or an hour-glass-like shape. The slated shape of the at least one through hole may be created by a laser drilling process. The slated shape of the at least one through hole may promote the formation of a bridging structure inside the at least one through hole and thus may enhance a void-free provision of the electrically conductive structure, especially when the electrically conductive structure comprises a metal.

According to a preferred embodiment of the present invention, the vertical extension of the electrically conductive structure may be slanted with respect to the stacking direction. Preferably, the vertical extension of the electrically conductive structure may at least partially, in particular fully, follow the direction of the contour of the at least one through hole. This may bring the advantage of ensuring a good physical interaction, in particular adhesion, between the electrically conductive structure and the sidewall of the at least one through hole.

According to another embodiment of the present invention, the vertical extension of the (portion of the) cap structure inside the at least one through hole may be slanted with respect to the stacking direction. This may bring the advantage of reliably void-free filling the at least one through hole by the cap structure, even if the at least one through hole comprises a slated shape. Additionally or alternatively, the vertical extension of the (portion of the) cap structure inside the at least one through hole may be parallel to stacking direction.

According to a further embodiment of the present invention, the average lateral extension of the cap structure inside the at least one through hole may be larger than the average lateral extension of the electrically conductive structure. As average lateral extension it is meant, the average extension (diameter) of the (integer of) the lateral extensions (diameters) extending along the vertical direction of the cap and/or of the electrically conductive structure, said lateral extensions (diameters) being in particular variable due to the preferred slanted shape of the cap and/or of the electrically conductive structure This may be a fingerprint of the applied method (for example forming the at least one through hole by laser drilling). The cap structure may be able to follow the contour of the at least one through hole. Since the at least one through hole may comprise a slanted shape, the cap structure may fully fill the at least one through hole in lateral extension, and thus the average lateral extension of the cap structure inside the at least one through hole may be larger than the average lateral extension of the electrically conductive structure. Additional or alternatively, the average lateral extension of the cap structure inside the at least one through hole may be the same as the average lateral extension of the electrically conductive structure.

According to a preferred embodiment of the present invention, the sidewall of the at least one through hole may comprises two slanted portions, a first portion being slanted from one of the two main surfaces toward the center of the electrically insulating layer structure, and a second portion being slanted from the other one of the two main surfaces toward the center of the electrically insulating layer structure, said two slanted portions being connected one to each other. The two slanted portion may be connected at a central region of the electrically insulating layer structure defining a connecting plane. Optionally, the sidewall of the at least one through hole may comprise a third portion, preferably a third (slanted) portion. The third (slanted) portion may be provided between the first slated portion and the second slated portion. Preferably, the third (slanted) portion may be connected to the first slanted portion and the second slanted portion. The third (slanted) portion may comprise straight sidewall. The sidewall of the third portion may be parallel to the stacking direction. Alternatively, the sidewall of the third portion may be slanted in regard to stacking direction. The inclination angle of the first slanted portion and the second slanted portion may be different. In an example, the sidewall of the at least one through hole may comprise the shape like the letter "X". The at least one through hole comprising two slanted portions may be created by two laser drilling process steps. The first of the laser drilling process step may be applied at the first main surface of the electrically insulating layer structure and the second laser drilling process step may be applied at the second main surface of the electrically insulating layer structure. These slanted portion, that may be the footprint of a laser drilling from both sides of the at least one electrically insulating layer structure forming the through hole, may bring the advantage of reducing the amount of metal for filling the at least one through hole due to the geometrical shape of the at least one through hole.

According to another embodiment of the present invention, the electrically conductive structure may fully fill a portion of the at least one through hole. Preferably, the electrically conductive structure may from the bridge structure. This may ensure a high content of electrically conductive material inside the at least one through hole and thus may ensure a low-loss transmission of an electric signal and/or electric current.

According to a further embodiment of the present invention, the sidewall of the at least one through hole comprises a vertically straight shape. The at least one through hole may be created by a mechanical drilling process step. Mechanical drilling may save processing time, especially when the thickness of the at least one electrically insulating layer structure is larger than 150 µm in particular 300 µm.

According to a preferred embodiment of the present invention, the at least one electrically insulating layer structure may comprise fillers, in particular fibers. Additionally, the at least one electrically insulating layer structure may comprise filler particles. The fillers may comprise inorganic material, in particular glass and/or barium sulfate. This may bring the advantage of imparting physical properties to the at least one electrically insulating layer structure, in particular stiffness.

According to another embodiment of the present invention, a portion of the fillers may be at least partially exposed in the at least one through hole, said at least partially exposed fillers being embedded in said electrically conductive structure. The fillers may reinforce the electrically conductive structure in lateral direction. This may increase the stability of the electrically conductive structure against shear stress and/or pressure.

A component carrier according to a further embodiment of the present invention, the exposed fillers may be provided at the vertical extremity of the electrically conductive structure, in particular at the vertical extremity distanced from one of the two main surfaces of the at least one electrically insulating structure. This may enhance the stability of the at least one through hole, especially at the portion of the at least one through hole close to the extremities and/or openings. Additionally or alternatively, the exposed fillers may be provided at a central position of the at least one through hole.

According to a preferred embodiment of the present invention, some of the exposed fillers are in contact with the electrically conductive structure and other exposed fillers are (only) in contact with the electrically conductive layer structure. The may bring the advantage of increasing the stability of the electrically conductive structure and the electrically conductive layer structure against shear stress and/or pressure.

According to another embodiment of the present invention, the stack may comprise at least two, in particular a plurality of, electrically conductive layer structures. The at least two electrically conductive layer structure may be stacked one above the other in stacking direction. Preferably, at least one electrically insulating layer structure may be provided between the at least two electrically conductive layer structures. The plurality of electrically conductive layer structure may be interconnected with each other by further electrically conductive structures being similar as the electrically conductive structures.

According to a further embodiment of the present invention, the stack may comprise at least two, in particular a plurality of, electrically insulating layer structures. This may enlarge the amount of electrically conductive layer structure being separated by the electrically insulating layer structures and thus a complex component carrier can be manufactured.

According to another embodiment of the present invention, the stack may comprise a component at least partially embedded in the at least one electrically insulating layer structure and/or being surface mounted at one main surface of the stack. This may bring the advantage of increasing the functionality of the component carrier.

According to a preferred embodiment of the present invention, forming the at least one through hole may comprise a material removal process step, in particular a mechanical drilling process step and/or a laser drilling process step. The material removal process step may be applied at one main surface or at both main surface of the at least one electrically insulating layer structure. Depending of the material removal process step, different shapes of the sidewall of the at least one through hole may be achieved. For example, when a mechanical drilling process step is used, a sidewall may be created having a straight shape being parallel to stacking direction. On the other hand, when a laser drilling process step is used, a sidewall may be created having an irregular shape and/or being slated in regard to stacking direction. Nonetheless, both material removal process steps may reliable remove the material of the at least one electrically insulating layer structure and optionally the electrically conductive layer structure creating the at least one through hole from one main surface to the second main surface of the stack, in particular the at least one electrically insulating layer structure.

According to another embodiment of the present invention, providing the electrically conductive structure may comprise a metal deposition process step, in particular a galvanic plating process step and/or electro-less metal deposition process step and/or a physical vapor deposition process step and/or a chemical vapor deposition process step. Additionally or alternatively, providing the electrically conductive structure may comprise a process of providing a sinter paste or a solder paste. Preferably, an electroless metal deposition process step and/or a physical vapor deposition process step and or a chemical vapor deposition process step may be applied to form a seed layer at an electrically insulating layer structure, in particular the sidewall of the at least one through hole. Preferably, the seed layer may comprise the first layer of the electrically conductive structure and/or the first layer of the cap structure. A galvanic plating process step may be used to provide a bigger ratio of a metal in comparison the aforementioned process step. For example, when the electrically conductive structure and/or the electrically conductive layer structure and/or the cap structure comprises at least two layer structure, one of the at least two layer structure may be created by an electro-less metal deposition process step and/or a physical vapor deposition process step and or a chemical vapor deposition process step whereas another of the at least two layer structures may be created by a galvanic plating process step. The may ensure a reliable adhesion between the surface of the at least one electrically insulating layer structure, in particular the sidewall of the at least one through hole, and the electrically conductive material, in particular the electrically conductive layer structure and/or the electrically conductive structure and/or the cap structure. Additionally or alternatively, this may ensure a reliable void-free filling of the electrically conductive structure inside the at least one through hole.

According to a further embodiment of the present invention, providing the electrically conductive structure may comprise a material removal process step. Preferably, the material removal process step may comprise a metal removal process step, for example a wet chemical etching step. Additionally or alternatively, the material removal process step may comprise a plasma etching step. The material removal process step may be free from a grinding process step. This may ensure that the electrically conductive structure is vertically delimited inside the at least one through hole. In other words, the electrically conductive structure may not extend over the vertical extension of the at least one electrically insulating layer structure. Since a plurality of though holes having different shapes may be filled with the electrically conductive structure within one manufacturing process step or the distribution of a plurality of through holes in one area of the component carrier may be different in comparison to another distribution of another plurality of through holes in another area of the same component carrier, at least one of the at least one through holes may filled such, that the electrically conductive material extends beyond the vertical extension of the at least one electrically insulating layer structure. This may create issues in further process steps since not all of the plurality of the though holes are filled beyond the vertical extension of the at least one electrically insulating layer structure with the electrically conductive material. In order to level out the deviation of the level of the extremity of the electrically conductive structure between the different through holes the material removal process step may be applied. This may result in a uniform vertical level of the extremity of the electrically conductive structure within all through holes having a respective shape.

According to another embodiment of the present invention, providing the electrically conductive structure and/or the electrically conductive layer structure and/or a cap structure may comprise a further metal deposition process step, in particular a galvanic plating process step and/or electro-less metal deposition process step and/or a physical vapor deposition process step and/or a chemical vapor deposition process step. In an example, the metal deposition process step and the further metal deposition process step may provide the same metal, for example copper. Nevertheless, the metal provided by the metal deposition process may be distinguishable from the metal provided by the further metal deposition process step. This may bring the advantage of fully and void-free filling the at least one through hole, in particular the plurality of through holes. Additionally, the exposed electrically conductive layer structure and the cap structure may have similar vertical extension. The similar vertical extension of the exposed electrically conductive layer structure and the cap structure may include a deviation in the range from 1 µm to 10 µm, in particular in the range between 1 µm and 5 µm.

According to a preferred embodiment of the present invention, the method of manufacturing the component carrier may comprise the step of providing a plug structure in the at least one through hole. The plug structure may be provided by a dispensing process step and/or providing the plug structure into the at least one through hole by the application of vacuum.

The preferred embodiments presented with reference to a component carrier according to the first aspect of the present invention and its advantages apply correspondingly to a method according to the second aspect of the present invention.

Further features of the invention are shown in the claims, the figures, and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.

### Brief Description of the Drawings

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2A to Figure 2H illustrate cross-sectional views of structures obtained during carrying out a first method of manufacturing a component carrier according to an exemplary embodiment of the invention.
Figure 3A to Figure 3I illustrate cross-sectional views of structures obtained during carrying out a second method of manufacturing a component carrier according to an exemplary embodiment of the invention.
Figure 4A to Figure 4H illustrate cross-sectional views of structures obtained during carrying out a third method of manufacturing a component carrier according to an exemplary embodiment of the invention.
Figure 5 illustrates a top view of a component carrier according to an exemplary embodiment of the invention.
Figure 6 illustrates a microscopic image of a component carrier according to an exemplary embodiment of the invention.
Figure 7 illustrates results of thickness measurements, according to an exemplary embodiment of the invention.
Figure 8 illustrates a cross-sectional view of a component carrier according to an exemplary embodiment of the invention.

### Detailed Description of the Drawings

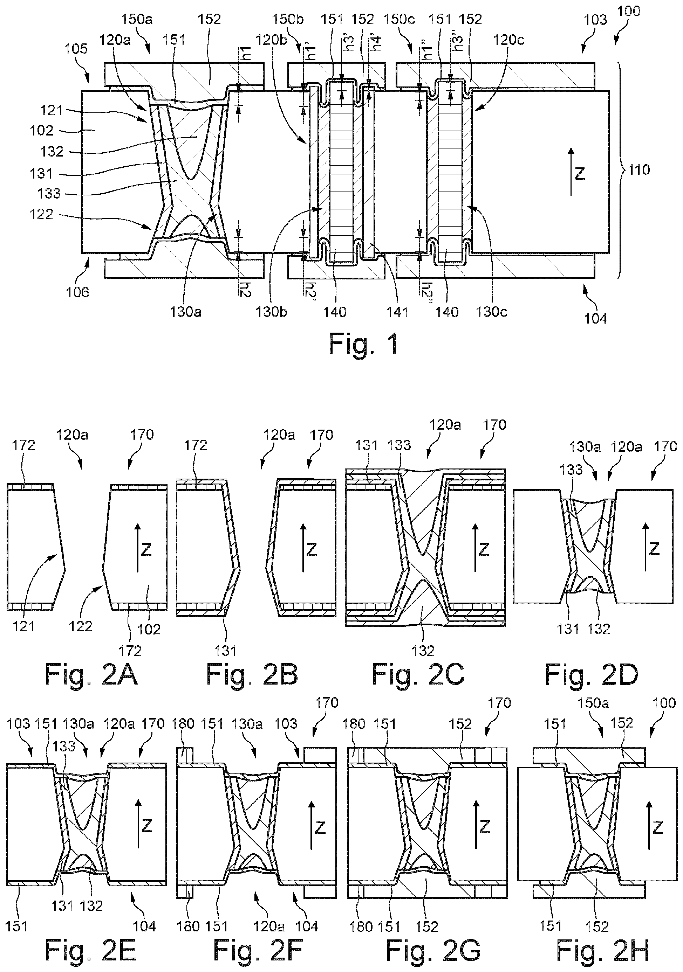

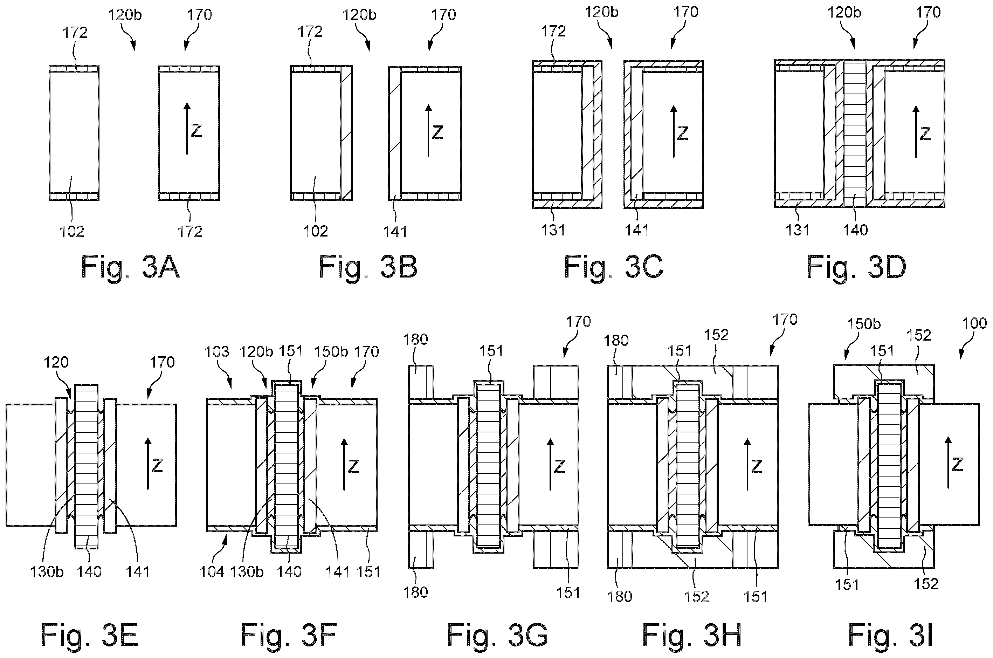

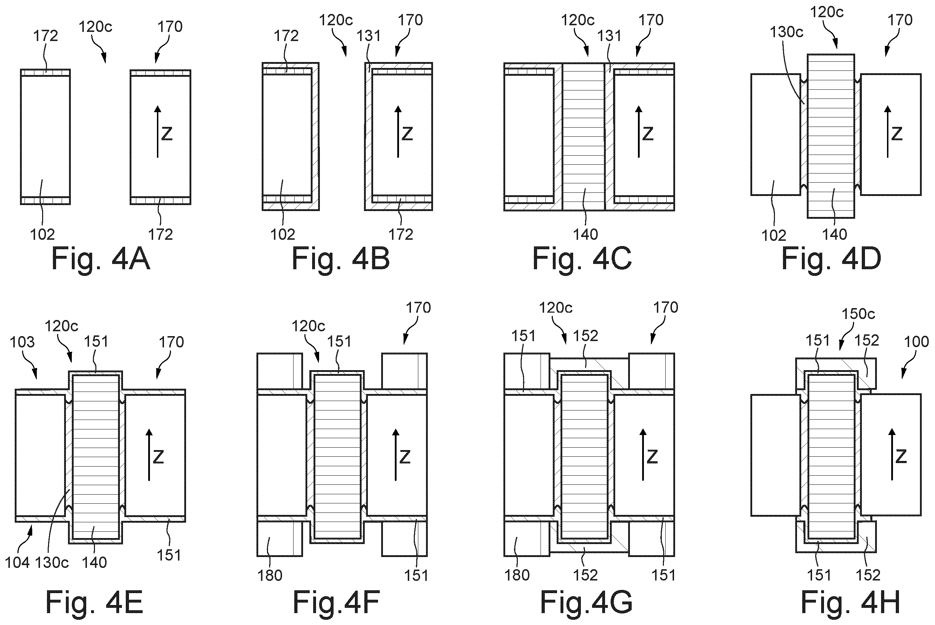

Figure 1 shows a cross-sectional view of a component carrier 100 as an exemplary embodiment of the present invention. The component carrier 100 comprises a stack 110 comprising an electrically insulating layer structure 102 comprising three possible through holes 120a, 120b, 120c, realized according to one common embodiment of the present invention, passing through said electrically insulating layer structure 102. Preferably, the electrically insulating layer structure 102 may comprise an organic polymeric material, for example an epoxy resin and/or a poly (meth)acrylate. Additionally or alternatively, the electrically insulating layer structure 102 may comprise an inorganic material, for example glass and/or ceramic. Additionally, the stack 110 comprises a first electrically conductive layer structure 103 provided on a first main surface 105 of the electrically insulating layer structure 102 and a second electrically conductive layer structure 104 provided on a second main surface 106 of the electrically insulating layer structure 102. Preferably, the electrically conductive layer structures 103, 104 may comprise copper. The first electrically conductive layer structure 103, the second electrically conductive layer structure 104 and the electrically insulating layer structure 102 are stacked one above the other in stacking direction Z. Thereby the electrically insulating layer structure 102 is provided, in particular sandwiched, between the respective two electrically conductive layer structures 103, 104. The sidewall of the first through hole 120a comprises a slanted shape, in particular two slanted portions 121, 122. The first slanted portion 121 is slanted from the first main surface 105 towards the center of the electrically insulating layer structure 102 and the second slanted portion 122 is slanted from the second main surface 106 toward the center of the electrically insulating layer structure 102 in regard to stacking direction Z. The two slanted portions 121, 122 are connected one to each other, in particular at a central region of the electrically insulating layer structure 102 defining a connecting plane. This slanted shape of the sidewalls of the first through hole 120a comprises a X-shape. The sidewalls of the respective second through hole 120b and third through hole 120c comprise vertically straight shapes in regard to stacking direction Z. The first through hole 120a may be created by a laser drilling process step, whereas a first laser pulse may be provided at the first main surface 105 and a second laser impulse may be provided at the second main surface 106. The second through hole 120b and the third through hole 120c may be created by a mechanical drilling process step. In the shown embodiment of Figure 1, the second through hole 120b has an extension larger than the extension of the third through hole 120c in regard to a direction being perpendicular to stacking direction Z. In a preferred component carrier, the respective through holes may have the same shape and/or may have same extension with regard to a direction being perpendicular to stacking direction Z (not shown). An electrically conductive structure 130a, 130b, 130c is in contact with a sidewall of the respective through hole 120a, 120b, 120c, wherein said respective electrically conductive structure 130a, 130b, 130c partially vertically extends along the vertical extension of the sidewall. The first electrically conductive structure 130a is associated to the first through hole 120a, the second electrically conductive structure 130b is associated to the second through hole 120b and the third electrically conductive structure 130c is associated to the third through hole 120c. The respective electrically conductive structures 120a-120c are vertically distanced from one main surface, in particular both main surfaces 105, 106 of the electrically insulating layer structure 102. The first electrically conductive structure 130a and the third electrically conductive structure 130c are in direct contact with the sidewall of the respective through hole 120a, 120c. The second electrically conductive structure 130b is free from direct contact with the sidewall of the through hole 120b. Within the context of the present shown embodiments, the distance from the first main surface 105 to the first electrically conductive structure 130a is called h1, the distance from the first main surface 105 to the second electrically conductive structure 130b is called h1' and the distance from the first main surface 105 to the third electrically conductive structure 130c is called h1" in regard to stacking direction Z. Within the context of the present shown embodiments, the distance from the second main surface 106 to the first electrically conductive structure 130a is called h2, the distance from the second main surface 106 to the second electrically conductive structure 130b is called h2' and the distance from the second main surface 106 to the third electrically conductive structure 130c is called h2" in regard to stacking direction Z. The length of the distances h1 and h2 are the same, whereas the length of the distance h1" and h2" are different. The distances h1 and h2 are constant along the horizontal extension of the respective electrically conductive structure, whereas the distances h1" and h2" vary along the horizontal extension of the respective electrically conductive structure. The respective electrically conductive structure 130a-130c comprises a layer structure, in particular the electrically conductive structure 130a is shown as comprising two layer structures 131, 133 partially covering the sidewall of the respective through hole 120a. The first layer structure 131 is in direct contact with the sidewall of the respective through hole 120a-120c. For simplification, only two layer structures 131, 133 are shown within the first through hole 120a, but additional layer structures can be additionally provided. The first layer structure 131 may comprise copper and/or palladium and/or titanium. The second layer structure 133 is in indirect contact with the sidewall of the first through hole 120a. The second layer structure may comprise copper. The vertical extension of the first electrically conductive structure 130a is slanted with respect to stacking direction Z. The vertical extension of the respective electrically conductive structures 130b, 130c are parallel to stacking direction Z. The shown electrically conductive structures 130a fully fill the volume of the respective through holes 120a along a partial vertical extension of the respective through holes 120a, in particular forming the bridging structure Preferably, the bridging structure may be (part of) a plated metal structure. The shown second through hole 120b comprises a first plug structure 140 and a second plug structure 141. The first plug structure 140 is in direct contact with the respective electrically conductive structure 130b, 130c. At least a portion of the sidewall of first plug structure 140 is covered by the respective electrically conductive structure 130b, 130c. The first plug structure 140 extends beyond the first main surface 105 of the electrically insulating layer structure. Within the context of the present embodiments, the distance from the first main surface 105 of the electrically insulating layer structure 102 to the first plug structure 140 is called h3 in regard to stacking direction Z. In particular, the distance of h3 in regard to the second though hole 120b is called h3' and the distance of h3 in regard to the third through hole 120c is called h3". The second plug structure 141 is in direct contact with the electrically insulating layer structure 102, in particular the sidewall of the second through hole 120b, and the second electrically conductive structure 130b. Additionally or alternatively, the first plug structure 140 extends beyond the first main surface 105 of the electrically insulating layer structure 102. Within the context of the present embodiments, the distance from the first main surface 105 to the second plug structure 141 is called h4' in regard to stacking direction Z. The contact area between the second plug structure 141 and the electrically insulating layer structure 102 is preferably larger than the contact area between the second plug structure 141 and the second electrically conductive structure 120b. The respective distances of h3 and h4 may larger than 0.5 µm, in particular may be in the range from 0.5 µm to 10 µm. The distance h3' is larger than the distance h4'. Alternatively, the distance h3' and h4' may be the same and/or may be zero. In other word, the first plug structure 140 and/or the second plug structure 141 may be flush with the first main surface 105. The distances h3 and h4 may depend on the manufacturing process of the stack 110. The first plug structure 140 and/or the second plug structure 141 may comprise an electrically insulating material and/or a magnetic material and/or may be perforated. The first plug structure 140 and/or the second plug structure 141 may comprise a paste, in particular a hardened paste. The plug structure 140, 141 h3 and/or h4 extend(s) beyond the respective extremity of the electrically conductive structure 130b, 130c. A recessed ring is formed by the sidewall of the respective through hole 120b, 120c the extremity of the respective electrically conductive structure 130b, 130c and a lateral wall of the plug structure 140, 141. The shown electrically conductive structure 130b, 130c comprises one layer structure 131 defining an internal volume, said volume being filled by the first plug structure 140. The sidewall of the second through hole 120b defines another internal volume, said other internal volume being filled by the second plug structure 141. The first plug structure 140 and the second plug structure 141 extend parallel to stacking direction Z in a coaxial manner one to each other. The first plug structure 140 and the second plug structure 141 are separated from each other by the second electrically conductive structure 130b. The first electrically conductive layer structure 103 and/or the second electrically conductive layer structure 104 are in contact with the respective electrically conductive structures 130a-130c. The electrically conductive layer structures 103, 104 are electrically connected with one extremity of the respective electrically conductive structures 130a-130c. The electrically conductive layer structures 103, 104 partially extend internally in the respective through holes 120a-120c. In the shown embodiment one cap structure 150 is provided. A first cap structure 150a is associated to the first through hole 120a, a second cap structure 150b is associated to the second through hole 120b and a third cap structure 150c is associated to the third through hole 120c. The respective caps structures 150a-150c are provided in the respective through holes 120a-120c. The respective caps structures 150a-150c fully covers the extremity of the respective through holes 120a-120c. The first extremity and the opposed second extremity of the respective same through hole 120a-120c is covered by the cap structures 150a-150c. The respective cap structures 150a-150c comprise the first electrically conductive layer structure 103 or the second electrically conductive layer structure 104. The respective cap structures 150a-150c comprise an external portion in contact with the first main surface 105 or the second main surface 106 of the electrically insulating layer structure 102. The shown cap structures 150a-150c comprise two layer structures, in particular a further first layer structure 151 and a further second layer structure 152. Preferably, the cap structures 150a-150c comprises electrically conductive material. The further first layer structure 151 of the respective cap structure 150a-150c may comprise titanium and/or palladium and/or copper. The further second layer structure 152 of the respective cap structure 150a-150c may comprise copper. The further first layer structure 151 is in direct contact with the respective electrically conductive structure 130a-130c, in particular the first layer structure 131 and/or the plated metal structure 132 of the respective electrically conductive structure 130a-130c. Additionally or alternatively, the further first layer structure can be in direct contact with the bridging structure (not shown). The shown further first layer structure 151 is in direct contact with the sidewall of the respective through holes 120a-120c. The shown further second layer structure 152 follow the contour of the further first layer structure 151. As shown, the further first layer structure 151 and the further second layer structure 152 may be stacked one above the other. Preferably, the extension in the thickness direction of the further first layer structure 151 of the respective is smaller than the extension in the same direction of the first layer structure 131 of the respective electrically conductive structure 130a-130c. In the shown example, the extension in the thickness direction Z of the further first layer structure 151 of the respective cap structure 150a-150c may be in the range from 10 nm to 500 nm, whereas the extension in the same direction of the first layer structure 131 of the respective electrically conductive structure 130a-130c may be in the range from 0.5 µm to 5 µm. The lateral extension of the further first layer structure 151 of the respective shown cap structure 150a-150c is smaller than the lateral extension of the further second layer structure 152 of the same respective cap structure 150a-150c. The shown recessed ring of the shown second electrically conductive structure 130b and of the shown third electrically conductive structure 130c is filled with the further first layer structure 151 and the further second layer structure 152 of the respective cap structure 150b, 150c. The external portion of the respective cap structure 150a-150c has a lateral extension larger than the lateral extension of the respective through hole 120a-120c. The contact between the respective cap structure 150a-150c and the respective electrically conductive structure 130a-130c defines a boundary profile. The boundary profile follows the profile of the respective electrically conductive structure 130a-130c and/or the respective cap structure 150a-150c. The further first layer structure 151 of the respective cap structures 150a-150c is in contact with the respective electrically conductive structure 130a-130c and the further second layer structure 152 of the respective cap structure 150a-150c is in contact with the further first layer structure 151 at the opposed side with respect to the side of the respective electrically conductive structure 130a-130c. The vertical extension of the shown first cap structure 150a inside the first through hole 120a is slanted with respect to stacking direction Z. The average lateral extension of the first cap structure 150a inside the first through hole 120a is larger than the average lateral extension of the first electrically conductive structure 130a. Optionally, the first electrically conductive layer structure and/or the second electrically conductive layer structure may comprise at least two layer structures, in particular a first sub-layer structure and a second sub-layer structure, wherein the first sub-layer structure of the electrically conductive layer structure may comprise the first layer structure of the cap structure and the second sub-layer structure of the electrically conductive layer structure may comprise the second layer structure of the cap structure. Optionally, the component carrier may comprise a plurality of through holes, each of them comprising the same shape or different shapes. Further optionally, the component carrier may comprise at least two filled through holes as shown in Figure 2H, or as shown in Figure 3I, or as shown in Figure 4H or a combination thereof.

A component carrier 100, for example as shown in Figure 1 or similar, can be manufactured by a combination of the explained process steps described in Figure 2A to Figure 2H.

Figure 2A shows a cross-sectional view of a preform of a component carrier 170 as an exemplary embodiment of the present invention. The preform of the component carrier 170 comprises an electrically insulating layer structure 102 and two clad layer structures 172. One of the clad layer structure 172 is provided at the first main surface 105 of the electrically insulating layer structure 102 and the other one of the two clad layer structures 172 is provided at the second main surface 106 of the electrically insulating layer structure 102. The clad layer structures 172 may comprise electrically conductive material, in particular a metal, for example copper. The two clad layer structures 172 and the electrically insulating layer structure 102 are stacked one above the other in regard to stacking direction Z. A first through hole 120a is formed in the electrically insulating layer structure 102 and the two clad layer structures 172. The first through hole 120a extends from one main surface of the preform of the component carrier 170 to the second main surface of the preform of the component carrier 170. The first through hole 120a is formed by a laser drilling process step. Thereby, a first laser pulse may be applied at the first main surface of the preform of the component carrier 170 and a second laser pulse may be applied at the second main surface of the preform of the component carrier 170. The laser drilling process step forms a first slanted portion 121 and a second slanted portion 122.

Figure 2B shows a cross-sectional view of a preform of a component carrier 170 in a subsequent process step as an exemplary embodiment of the present invention. In addition to Figure 2A, Figure 2B comprises a first layer structure 131. The first layer structure 131 is provided at the exposed surface of the preform of the component carrier 170. Preferably, the first layer structure 131 is provided at the sidewall of the through hole 120. Additionally, the first layer structure 131 is provided at the exposed main surface of the clad layer structure 172. The first layer structure 131 may be provided by an electro-less deposition process step and/or a physical vapour deposition process step and/or a chemical vapour deposition process step. The first layer structure 131 may comprise a thickness from 10 nm to 5 µm. Preferably, first layer structure 131 may comprise copper and/or titanium and/or palladium. The first layer structure 131 follows the contour of the sidewall of the first through hole 120a.

Figure 2C shows a cross-sectional view of a preform of a component carrier 170 in a subsequent process step as an exemplary embodiment of the present invention. In addition to Figure 2B, Figure 2C comprises a plated layer structure 133 comprising a bridging structure and a plated metal structure 132. The plated layer structure 133 may be considered as a second layer structure. The plated metal structure may be considered as a plug structure. The shown plated layer structure 133 is in direct contact with the first layer structure 131 and the plated metal structure 132. The shown plated layer structure 133 may be formed by a galvanic plating process step and/or may comprise copper. The shown plated layer structure 133 follows the contour of the first layer structure 131. The shown plated layer structure 133 is provided in the first through hole 120a and at the exposed main surface of the first layer structure 131 outside the first through hole 120a. The thickness of the shown plated layer structure 133 varies in the through hole 120, whereas the thickness of the shown plated layer 133 is constant outside the through hole 120. The plated metal structure 132 is in direct contact with the bridging structure of the plated layer structure 133. The shown plated metal structure 132 follows the contour of the plated layer structure 133. The plated metal structure 132 is provided in the first through hole 120a. Additionally, the plated metal structure 132 is provided at the exposed main surface of the plated layer structure 133 outside the first through hole 120a. The plated metal structure 132 may be formed by a galvanic plating process step and/or may comprise copper. The thickness of the shown plated metal structure 132 varies in the first through hole 120a, whereas the thickness of the plated metal structure 132 is constant outside the first through hole 120a. The shown plated metal structure 132 forms a dimple at the exposed main surface at the portion of the first through hole 120a. The first layer structure 131, the plated layer structure 133 and the plated metal structure 132 fully fill the first through hole 120a (i.e. in direction parallel to stacking direction Z and in direction perpendicular to stacking direction Z).

Figure 2D shows a cross-sectional view of a preform of a component carrier 170 in a subsequent process step as an exemplary embodiment of the present invention. In addition to Figure 2C, Figure 2D the first layer structure 131, the plated layer structure 133 and the plated metal structure 132 are at least partially removed. Additionally, the clad layer structure 172 is completely removed. The removal of the aforementioned elements of the preform of the component carrier 170 may be done by a material removal process step, in particular a metal removal process step. The metal removal process step may comprise a wet chemical etching step. During the material removal process step, the first layer structure 131, the plated layer structure 133 and the plated metal structure 132 are completely removed from the first main surface 105 and the second main surface 106 of the electrically insulating layer structure 102. Additionally, the material of the first layer structure 131, the plated layer structure 133 and the plated metal structure 132 is at least partially removed inside the first through hole 120a such that the resulting first electrically conductive structure 130a partially vertically extends along the vertical extension of the sidewall of the first through hole 120a. Depending on the flow dynamics of the etching medium, the material of the plated metal structure 132 may be removed to a higher extend compared to the plated layer structure 133 and the first layer structure 131. Thereby an indentation in the plated metal structure 132 is formed. Alternatively, the material removal process step may be performed such that at least a portion of the clad layer structure and optionally the first layer structure and optionally the plated layer structure and optionally the plated metal structure remain at the first main surface and the second main surface of the electrically insulating layer structure (not shown).

Figure 2E shows a cross-sectional view of a preform of a component carrier 170 in a subsequent process step as an exemplary embodiment of the present invention. In addition to Figure 2D, Figure 2E comprises a further first layer structure 151. The further first layer structure 151 may be formed by a physical vapour deposition process step and/or a chemical vapour deposition process step and/or an electro-less deposition process step. The further first layer structure 151 may comprise titanium and/or copper and/or palladium. The further first layer structure 151 follows the contour of the electrically insulating layer structure 102, in particular the first main surface 105 and (separately) the second main surface 106 of the electrically insulating layer structure 102. Additionally, the further first layer structure 151 follows the contour of the sidewall of the through hole 120, first layer structure 131, the plated layer structure 133 and the plated metal structure 132 of the electrically conductive structure 130.

Figure 2F shows a cross-sectional view of a preform of a component carrier 170 in a subsequent process step as an exemplary embodiment of the present invention. In addition to Figure 2E, Figure 2F comprises a mask structure 180. The mask structure 180 is provided at the exposed surface of the preform of the component carrier 170, in particular, the further first layer structure 151. The mask material 180 may comprise electrically insulating material, for example resin material. The mask material 180 is structured in order to cover dedicated portions of the exposed surface of the component carrier 100.

Figure 2G shows a cross-sectional view of a preform of a component carrier 170 in a subsequent process step as an exemplary embodiment of the present invention. In addition to Figure 2F, Figure 2G comprises a further second layer structure 152. The further second layer structure 152 may be formed by a galvanic plating process step. The further second layer structure 152 may comprise copper. The shown further second layer structure 152 follows the contour of the further first layer structure 151. Additionally, the shown further second layer structure 152 follows indirectly the contour of the sidewall of the first through hole 120a, first layer structure 131, the plated layer structure 133 and the plated metal structure 132. The exposed surface of the further second layer structure 152 and the exposed surface of the mask structure 180 can be flush in regard to a direction being perpendicular to stacking direction Z.

Figure 2H shows a cross-sectional view of a component carrier 100 in a subsequent process step as an exemplary embodiment of the present invention. In addition to Figure 2G, Figure 2H the mask structure 180 is removed. The removal of the mask structure 180 may be done by a stripping process step. Additionally, a further material removal process step is performed. The further material removal process step may comprise a further wet chemical etching step. The further material removal process step may partially remove the further first layer structure 151. Preferably, the further first layer structure 151 may be removed which are not covered by the further second layer structure 152. In an embodiment the conditions of the material removal process step the conditions of the further material removal process step may different. For example, a different etching medium may be used and/or different temperatures may be used. Therefore, the first layer structure 151 may be selectively removed. Alternatively, the further first layer structure 151 may be removed to a higher extend compared to the further second layer structure 152. The structures resulting from the further first layer structure 151 and the further second layer structure 152 comprise the first cap structure 150a above described for Figure 1. The lateral extension of the shown further second layer structure 152 is different than the lateral extension of the shown further first layer structure 151, see left side of Figure 2H. Alternatively, the lateral extension of further second layer structure 152 is the same as the lateral extension of the further first layer structure 151, see right side of Figure 2H. When the further first layer structure 151 and the further second layer structure 152 comprise or consist of the same material, for example copper, the material removal rate of the further first layer structure 151 and the further second layer structure 152 may be the same, in particular in a direction being perpendicular to stacking direction Z and thus the lateral extension of the further second layer structure 152 and the lateral extension of the further first layer structure 151 may be the same.

A component carrier 100, for example as shown in Figure 1 or similar, can be manufactured by a combination of the explained process steps described in Figure 3A to Figure 3I.

Figure 3A shows a cross-sectional view of a preform of a component carrier 170 as an exemplary embodiment of the present invention. The preform of the component carrier 170 is similar to the preform of the component carrier 170 shown in Figure 2A, however it differs in the fact, that the preform of the component carrier 170 comprises a second through hole 120b. The second through hole 120b comprises a different shape compared to the first through hole 120a shown in Figure 2A. The second though hole 120b comprises a sidewall having a vertically straight shape in regard to stacking direction Z. Preferably, the second through hole 120b may be provided by a mechanically drilling process step.

Figure 3B shows a cross-sectional view of a preform of a component carrier 170 in a subsequent process step as an exemplary embodiment of the present invention. In addition to Figure 3A, Figure 3B comprises a second plug structure 141. The second plug structure 141 may be provided by a screen printing process step and/or a dispensing step. Additionally, the second plug structure 141 may be provided by application of a vacuum, for example low than 200 mbar. Thereby the second plug structure 141 fully fill the second through hole 120b (not shown). The second plug structure 141 covers the lateral wall of the electrically insulating layer structure 102 and the lateral wall of the clad layer structure 172. Thereafter, a further material removal process step is performed. The further material removal process step may comprise a further mechanical drilling process step. Additionally or alternatively, a laser drilling process step and/or a plasma etching step. The further material removal process step creates an opening in the second plug structure 141 and thereby connects the two opposed surfaces of the preform of the component carrier 170. The sidewall of the opening extends in parallel direction to the sidewall of the second through hole 120b, in particular parallel to stacking direction Z. The main surface of the second plug structure 141 may be flush with the exposed main surface of the clad layer structure 172. The second plug structure may comprise electrically insulating material and/or magnetic material. The second plug structure 141 may be a paste, in particular a hardened paste.

Figure 3C shows a cross-sectional view of a preform of a component carrier 170 in a subsequent process step as an exemplary embodiment of the present invention. In addition to Figure 3B, Figure 3C comprises a first layer structure 131. Optionally, the preform of the component carrier may comprise a plated layer structure (not shown, see Figure 2C). The first layer structure 131 is in direct contact with the clad layer structure 172 and the second plug structure 141. The first layer structure 131 is in contact with the lateral wall of and the main surface of the second plug structure 141. Preferably, the electrically first layer structure 131 may follow the contour of the clad layer structure 172 and the second plug structure 141. Preferably, the first layer structure 131 defines a remaining empty volume of the second through hole 120b. The provision of the first layer structure 131 may comprise an electro-less plating step and optionally a galvanic plating step.

Figure 3D shows a cross-sectional view of a preform of a component carrier 170 in a subsequent process step as an exemplary embodiment of the present invention. In addition to Figure 3C, Figure 3D comprises a first plug structure 140. The first plug structure 140 is provided in the remaining empty volume of the second through hole 120b. The first plug structure 140 may comprise electrically insulating material. The first plug structure 140 may be a paste, in particular a hardened paste. The first plug structure 140 may be provided by a screen printing process step and/or a dispensing step. Additionally, the first plug structure 140 may be provided by application of a vacuum, for example low than 200 mbar. The second through hole 120b is fully filled by the first plug structure 140, the second plug structure 141 and the first layer structure 131. The first plug structure 140 is in direct contact with the first layer structure 131. The main surface of the first plug structure 140 is flush with the main surface of the first layer structure 131.

Figure 3E shows a cross-sectional view of a preform of a component carrier 170 in a subsequent process step as an exemplary embodiment of the present invention. In comparison to Figure 3D, Figure 3E the clad layer structure 172 is completely removed. Additionally, the first layer structure 131 is removed at the portion at both extremities of the second through hole 120b. In the second through hole 120b, the first layer structure 131 is at least partially removed forming the second electrically conductive structure 130b. A material removal process step as described in Figure 2D or similar may create the preform of the component carrier 170. A result of the material removal process step is that the distances h1 to h4 may be created. The distances h1 to h4 are not indicated within Figure 3E, however can be taken from Figure 1. The distances h1 and h2 may vary depending on the conditions of the etching medium. Preferably, the distances h1 and h2 may be in the range from 2 µm to 50 µm. The distance h3 may be the same as the thickness of the sum of the clad layer structure 172 and the second electrically conductive structure 130b in the portion outside the second through holes 120b, which were implemented for example in Figure 3D. The distance h4 may be the same as the thickness of the clad layer structure 172, which was implemented for example in Figure 3D. Preferably, the main surface of the second electrically conductive structure 130b may have a curved shape. Flow dynamics of the etching medium may be depressed in regions close the sidewalls of the first plug structure 140 and/or the second plug structure 141 which may yield in the final curved shape of the second electrically conductive structure 130b.

Figure 3F shows a cross-sectional view of a preform of a component carrier 170 in a subsequent process step as an exemplary embodiment of the present invention. In addition to Figure 3E, Figure 3F comprises a further first layer structure 151. The further first layer structure 151 may be provided similar or the same as described in Figure 2E. In the shown exemplary embodiment, the further first layer structure 151 may be in direct contact with the first plug structure 140 and/or the second plug structure 141. Preferably, the further first layer structure 151 may follow the contour of the electrically insulating layer structure 102 and/or the first plug structure 140 and/or the second plug structure 141 and/or the second electrically conductive structure 130b. Preferably, the second through hole 120b may be fully filled by the first plug structure 140, the second plug structure 141, the second electrically conductive structure 130b and the further first layer structure 151.

Figure 3G shows a cross-sectional view of a preform of a component carrier 170 in a subsequent process step as an exemplary embodiment of the present invention. In addition to Figure 3F, Figure 3G comprises a mask structure 180. The process step is similar or the same as describe in Figure 2F.

Figure 3H shows a cross-sectional view of a preform of a component carrier 170 in a subsequent process step as an exemplary embodiment of the present invention. In addition to Figure 3G, Figure 3H comprises a further second layer structure 152 as described in Figure 2G. In comparison to Figure 2G, the second through hole 120b is free from the further second layer structure 152. The further second layer structure 152 comprises a cavity, which is filled by the further first layer structure 151, the first plug structure 140 and the second plug structure 141.

Figure 3I shows a cross-sectional view of a component carrier 100 in a subsequent process step as an exemplary embodiment of the present invention. In addition to Figure 3H, Figure 3I the mask structure 180 is removed. The structures resulting from the further first layer structure 151 and the further second layer structure 152 comprise the second cap structure 150b above described for Figure 1. The process step is similar or the same as describe in Figure 2H.

A component carrier 100, for example as shown in Figure 1 or similar, can be manufactured by a combination of the explained process steps described in Figure 4A to Figure 4H.

Figure 4A shows a cross-sectional view of a preform of a component carrier 170 as an exemplary embodiment of the present invention. The preform of the component carrier 170 may be the same or similar as described in Figure 3A. The preform of the component carrier 170 comprises a third through hole 120c.

Figure 4B shows a cross-sectional view of a preform of a component carrier 170 in a subsequent process step as an exemplary embodiment of the present invention. In addition to Figure 4A, Figure 4B comprises a first layer structure 131. The process step of providing the first layer structure 131 is similar or the same as described in Figure 3C. In comparison to Figure 3C, the first layer structure 131 in the current embodiment is in direct contact with the sidewall of the third through hole 120c. Preferably, the sidewall of the third through hole 120c is fully covered by the electrically conductive structure 130.

Figure 4C shows a cross-sectional view of a preform of a component carrier 170 in a subsequent process step as an exemplary embodiment of the present invention. In addition to Figure 4B, Figure 4C comprises a first plug structure 140. The process step of providing the first plug structure 140 is similar or the same as described in Figure 3D.

Figure 4D shows a cross-sectional view of a preform of a component carrier 170 in a subsequent process step as an exemplary embodiment of the present invention. In comparison to Figure 4C, Figure 3D the clad layer structure 172 is completely removed.

Additionally, the first layer structure 131 is removed at both opposed main surfaces of the preform of the component carrier 170. Additionally, the first layer structure 131 is partially removed at the extremities of the third through hole 120c such that the resulting third electrically conductive structure 130c partially vertically extends along the vertical extension of the sidewall of the thrid through hole 120c. A material removal process step as described in Figure 3E or similar may create the preform of the component carrier 170. The third electrically conductive structure 130c is in direct contact with the electrically insulating layer structure 102 and the first plug structure 140.

Figure 4E shows a cross-sectional view of a preform of a component carrier 170 in a subsequent process step as an exemplary embodiment of the present invention. In addition to Figure 4D, Figure 4E comprises a further first layer structure 151. The further first layer structure 151 may be provided similar or the same as described in Figure 3F. In the shown exemplary embodiment, the further first layer structure 151 may be in direct contact with the first plug structure 140. Preferably, the further first layer structure 151 may follow the contour of the electrically insulating layer structure 102, the third electrically conductive structure 130c and the first plug structure 140.

Figure 4F shows a cross-sectional view of a preform of a component carrier 170 in a subsequent process step as an exemplary embodiment of the present invention. In addition to Figure 4E, Figure 4F comprises a mask structure 180. The process step is similar or the same as describe in Figure 3G.

Figure 4G shows a cross-sectional view of a preform of a component carrier 170 in a subsequent process step as an exemplary embodiment of the present invention. In addition to Figure 4F, Figure 4G comprises a further second layer structure 152. In comparison to Figure 3H, the further second layer structure 152 comprises a cavity, which is filled by the further first layer structure 151 and the first plug structure 140. The exposed main surfaces of the further second layer structure 152 and the exposed main surfaces of the mask structure 180 may be provided at different vertical levels in regard to stacking direction Z.

Figure 4H shows a cross-sectional view of a component carrier 100 in a subsequent process step as an exemplary embodiment of the present invention. In addition to Figure 4G, Figure 4H the mask structure 180 is removed. The structures resulting from the further first layer structure 151 and the further second layer structure 152 comprise the third cap structure 150c above described for Figure 1. The process step is similar or the same as describe in Figure 3I.

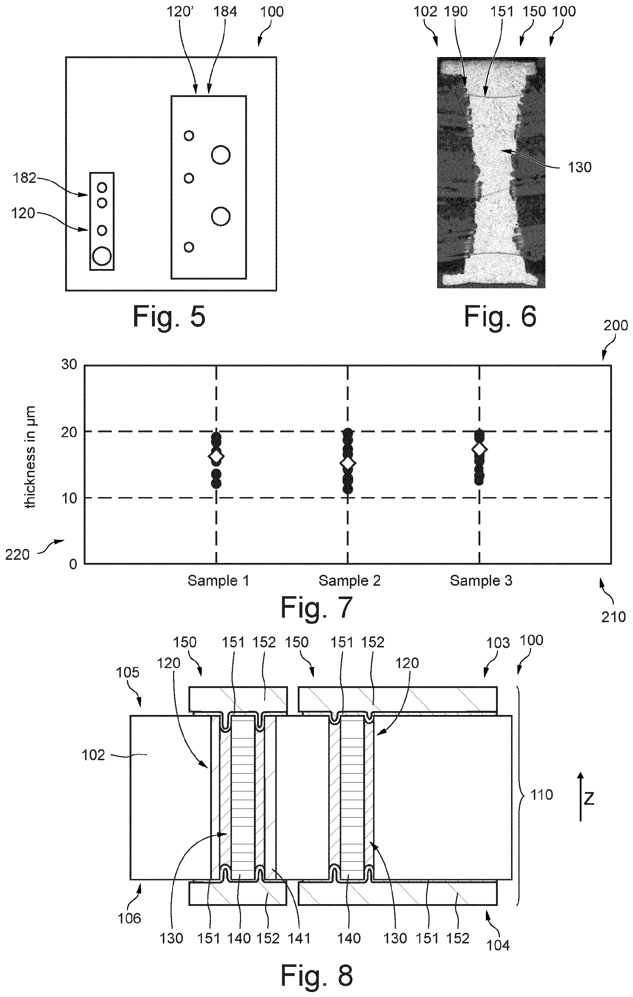

Figure 5 shows a top view of a component carrier 100 as an exemplary embodiment of the present invention. The component carrier 100 comprises a first portion 182 and a second portion 184. The first portion 182 comprises four through holes 120, wherein three of the four through holes 120 have the same extension, for example diameter, in one direction. The other, in particular the fourth, of the four through holes 120 has a different extension, in particular diameter, in comparison to the through holes 120 having the same diameter, one to each other. The second portion 184 comprises five further through holes 120', wherein three of the five further through holes 120' have the same extension, for example diameter, in one direction. Three of the five further through holes 120' have the same diameter as three of the four through holes 120. The other two, in particular the fourth and the fifth, of the five further through holes 120' have a different extension, in particular diameter, in comparison to the further through holes 120' having the same diameter, one to each other. The first portion 182 comprises a first area and the second portion 184 comprises a second area, wherein the first area and the second area are different. In particular, the second area is larger than the first area. The first portion 182 comprises a first distribution of the through holes 120 and the second portion 184 comprises a second distribution of the further through holes 120', wherein the ratio of the area filled by the through holes 120 in the first portion 182 is higher than the ratio of the area filled by the further through holes 120' in the second portion 184. This may result in different through hole densities in the first portion 182 and the second portion 184, which imparts the provision of the electrically conductive structures 130, in particular by a galvanic plating process step, since the local current densities of the of the first portion 182 and the second portion 184 may be different. Nevertheless, the manufacturing process as describe for example in Figure 2A to Figure 2H, or Figure 3A to Figure 3I, or Figure 4A to Figure 4H may reliably and fully fill the through holes 120 and the further through holes 120' with electrically conductive material 130. Additionally the thickness of the cap structures 150 and/or electrically conductive layer structures 103, 104 in regard to stacking direction Z may differ in an acceptable range, for example from 10 µm to 20 µm (see Figure 7).

Figure 6 shows a microscopic image of a component carrier 100 according to an exemplary embodiment of the invention. The component carrier 100 comprises an electrically insulating layer structure 102 comprising a plurality of fillers 190. Additionally, the component carrier 100 comprises a through hole 120 being filled by an electrically conductive structure 130. The shown fillers 190 are composed of fibers, in particular glass fibers. In the shown embodiment the fillers 190 are exposed in the through hole 120, said exposed fillers 190 are embedded in the electrically conductive structure 130. The fillers 190 are at least partially exposed in the through hole 120 such, that they are in direct contact with the electrically conductive structure 130 and the cap structure 150. Additionally, the at least partially fillers 190 are in direct contact with the resin material of the electrically insulating layer structure 102. Some of the fillers 190 are in contact with the electrically conductive structure 130 and other exposed fillers 120 are in contact with the cap structure 150 and/or the electrically conductive layer structure 103, 104. In the shown embodiment, the further first layer structure 151 of the cap structure 150 can be clearly seen. The grain size of the electrically conductive structure 130 is different than the grain size of the cap structure 150 and/or the electrically conductive layer structure 103, 104.

Figure 7 shows a diagram 200 illustrating results of thickness measurements. The abscissa 210 of the diagram 200 corresponds to different samples. The ordinate 220 of the diagram 200 corresponds to the thickness in regard to stacking direction Z of the corresponding samples. The thickness is provided in the scale of µm. The thickness of the sample corresponds to the distance in regard to stacking direction Z from the first main surface 105 of the electrically insulating layer structure 102 to the main surface of the cap structure 150. Sample 1 shows thickness measurements in regard to cap structures 150 being associated to a first portion 182 of a component carrier 100. The result of the thickness measurement of each respective cap structure 150 provided in the first portion 182 is represented by a respective circle. Sample 2 shows thickness measurements in regard to cap structures 150 being associated to a second portion 184 of a component carrier 100. The result of the thickness measurement of each respective cap structure 150 provided in the second portion 184 is represented by a respective circle. Sample 3 shows thickness measurements in regard to cap structures 150 being associated to a third portion of a component carrier 100. The result of the thickness measurement of each respective cap structure 150 provided in the third portion is represented by a respective circle. The mean value of the thickness measurement of each respective sample is represented in Figure 7 by a respective white square. All measurement points are within the range from 10 µm to 20 µm. The deviation of the mean values of the measurement points are smaller than 5 µm.

Figure 8 shows a cross-sectional view of a component carrier 100 as an exemplary embodiment of the present invention. The component carrier 100 is similar to the shown one in Figure 1, however in comparison the component carrier 100 comprises two through holes 120. One through hole 120 comprises a first plug structure 140 and a second plug structure 141, whereas the other through hole comprises a first plug structure 140 and is free of the second plug structure 141. The main surface of the first plug structure 140 and/or the second plug structure 141 are at the same vertical level in regard to stacking direction Z as the first main surface 105 and/or the second main surface 106 of the electrically insulating layer structure 102. In other words, the distances h3 and h4 may be zero. This may be achieved by a planarization process step, in particular a grinding step.

It should be noted that the term "comprising" does not exclude other elements or steps and the "a" or "an" does not exclude a plurality. Also, elements described in association with different embodiments may be combined.

Implementation of the invention is not limited to the preferred embodiments shown in the figures and described above. Instead, a multiplicity of variants is possible which use the solutions shown and the principle according to the invention, whose scope is defined by the appended claims.

### List of Reference Signs

- 100: component carrier
- 102: electrically insulating layer structure
- 103: first electrically conductive layer structure
- 104: second electrically conductive layer structure
- 105: first main surface of the electrically insulating layer structure
- 106: second main surface of the electrically insulating layer structure
- 110: stack
- 120: through hole
- 121: first slanted portion
- 122: second slanted portion
- 130: electrically conductive structure
- 131: first layer structure
- 132: plated metal structure
- 133: plated layer structure
- 140: first plug structure
- 141: second plug structure
- 150: cap structure
- 151: further first layer structure
- 152: further second layer structure
- 170: preform of the component carrier
- 172: clad layer structure
- 180: mask structure
- 182: first portion
- 184: second portion
- 190: fillers
- Z: thickness direction

## Claims

1. A component carrier (100) comprising:
a stack (110) comprising at least one electrically conductive layer structure (103, 104);
at least one electrically insulating layer structure (102) comprising at least one through hole (120) passing through said at least one electrically insulating layer structure (102);
an electrically conductive structure (130) in contact with a sidewall of the at least one through hole (120), said electrically conductive structure (130) partially vertically extending along the vertical extension of the sidewall.

2. A component carrier (100) according to claim 1,
wherein the electrically conductive structure (130) is vertically distanced from one of the two main surfaces (105, 106) of the at least one electrically insulating layer structure (102),
in particular wherein the electrically conductive structure (130) is vertically distanced from both of the two main surfaces (105, 106) of the at least one electrically insulating layer structure (102).

3. A component carrier (100) according to claim 1 or 2,
wherein the electrically conductive structure (130) comprises a layer structure (131) partially covering the sidewall of the at least one through hole (120),
in particular wherein the electrically conductive structure (130) comprises at least two layer structures (131, 133).

4. A component carrier (100) according to one of the claims 1 to 3, wherein the electrically conductive structure (130) fills at least partially, in particular fully, the volume of the at least one through hole (120) along a partial vertical extension of the at least one through hole (120).

5. A component carrier according to claim 4,
wherein the portion of the electrically conductive structure filling at least partially, in particular fully, the volume of the through hole comprises a bridging structure.

6. A component carrier (100) according to one of the claims 3 to 5, wherein the electrically conductive structure (130) comprises a plated metal structure (132), in particular plated copper structure, said plated metal structure (132) being in contact with a layer structure (133) comprised in the electrically conductive structure (130).

7. A component carrier (100) according to one of the claims 1 to 6, wherein the at least one through hole (120) comprises a plug structure (140, 141).

8. A component carrier (100) according to one of the claims 1 to 7,
wherein the at least one electrically conductive layer structure (103, 104) is in contact with the electrically conductive structure (130),
in particular wherein the at least one electrically conductive layer structure (103, 104) is in contact with one extremity of the electrically conductive structure (130) and/or wherein the at least one electrically conductive layer structure (103, 104) extends at least partially internally in the at least one through hole (120).

9. A component carrier (100) according to one of the claim 1 to 8,
wherein a cap structure (150) is provided in or at the extremity of the at least one through hole (120),
in particular wherein the cap structure (150) comprises an electrically conductive material.

10. A component carrier (100) according to claim 9,
wherein the cap structure (150) comprises an external portion in contact with a main surface (105, 106) of the electrically insulating layer structure (102).

11. A component carrier (100) according to claim 9 or 10,
wherein the cap structure (150) is in contact with the electrically conductive structure (130), in particular with the extremity of the electrically conductive structure (130) distanced from one of the two main surfaces (105, 106) of the at least one electrically insulating structure (102),
in particular wherein the contact between the cap structure (150) and the electrically conductive structure (130) defines a boundary profile, in particular said boundary profile having an irregular and/or curved surface extension.

12. A component carrier (100) according to one of the claims 1 to 11, wherein the sidewall of the at least one through hole (120) comprises a slated shape.

13. A component carrier (100) according to one of the claims 1 to 12, wherein the sidewall of the at least one through hole (120) comprises a vertically straight shape.

14. A component carrier according to one of the claims 1 to 13,
wherein the at least one electrically insulating layer structure (102) comprises fillers (190), in particular fibers,
in particular wherein a portion of the fillers (190) are exposed in the at least one through hole (120), said exposed fillers (190) being embedded in said electrically conductive structure (130).

15. A method of manufacturing a component carrier (100), the method comprising:
providing a stack (110) comprising at least one electrically conductive layer structure (103, 104);
providing at least one electrically insulating layer structure (102);
forming at least one through hole (120) in the at least one electrically insulating layer structure (102) such that the at least one through hole (120) passes through said at least one electrically insulating layer structure (102);
providing an electrically conductive structure (130) in contact with a sidewall of the at least one through hole (120), such that said electrically conductive structure (130) partially vertically extends along the vertical extension of the sidewall.
